Europäisches Patentamt

European Patent Office

Office européen des brevets

(19)

(11) Publication number: **0 154 670 B1**

# (12) EUROPEAN PATENT SPECIFICATION

(45) Date of publication of patent specification: **08.05.91**

(21) Application number: **84108806.5**

(22) Date of filing: **12.06.79**

(51) Int. Cl.⁵: **H01L 21/314,** H01L 21/28, H01L 29/62

(60) Publication number of the earlier application in accordance with Art.76 EPC: **0 072 603**

(54) **Process for producing a semiconductor device having insulating film.**

(30) Priority: **14.06.78 JP 71618/78**
**15.06.78 JP 72654/78**

(43) Date of publication of application:
**18.09.85 Bulletin 85/38**

(45) Publication of the grant of the patent:
**08.05.91 Bulletin 91/19**

(84) Designated Contracting States:
**DE GB NL**

(56) References cited:
DE-A- 1 644 012          FR-A- 2 223 836
FR-A- 2 313 770          GB-A- 2 004 693
US-A- 3 385 729          US-A- 3 520 722
US-A- 3 798 061          US-A- 4 056 642

(73) Proprietor: **FUJITSU LIMITED**
**1015, Kamikodanaka Nakahara-ku**
**Kawasaki-shi Kanagawa 211(JP)**

(72) Inventor: **Ito, Takashi**
**408 Noborito Tama-ku**
**Kawasaki-shi Kanagawa 214(JP)**
Inventor: **Nozaki, Takao**
**22-9, Chigusadai Midori-ku**
**Yokohama-shi Kanagawa 227(JP)**

(74) Representative: **Lawrence, Peter Robin**
**Broughton et al**
**GILL JENNINGS & EVERY 53-64 Chancery Lane**
**London WC2A 1HN(GB)**

JOURNAL OF THE ELECTROCHEMICAL SOCIETY: SOLID-STATE SCIENCE AND TECHNOLOGY, vol. 123, no. 7, July 1976, pages 1117-1120, Princeton, US; E. KOOI et al.: "Formation of silicon nitride at a Si -SiO2 interface during local oxidation of silicon and during heat-treatment of oxidized silicon in NH3 gas"

IBM TECHNICAL DISCLOSURE BULLETIN, vol. 19, no. 3, August 1976, page 905, New York, US; M.R. POPONIAK et al.: "Formation of thick Si3N4 or SixOyNz on SI substrate by anodnitridization"

Journal of the Electrochemical Society, vol. 120, no.3, March 1973, pages 446-453, Princeton, US; M.J.Rand et al.: "Silicon Oxynitride Films from the NO-NH3-SiH4 Reaction"

## Description

The present invention relates to a process for producing a semiconductor device having an insulating film. In particular the present invention relates to the manufacture of such a film as a gate insulation film of a MISFET, a dielectric of capacitor, a passivation film and as a mask for selectively forming circuit elements of semiconductor devices.

Materials that have been used as insulating films in silicon semiconductor devices in the past include silicon dioxide ($SiO_2$), silicon nitride ($Si_3N_4$) and silicon oxynitride ($SiO_xN_y$). Silicon dioxide is usually formed by a thermal oxidation of the silicon substrate or CVD or controlled vapour deposition process and thus, is inherently not dense. Silicon nitride has always been formed by CVD process or by directly nitridating silicon. Silicon oxynitride has been formed by a CVD process using $NH_3$, $O_2$ and $SiH_4$ gases.

It is also known to use a double film, wherein alumina ($Al_2O_3$), silicon nitride or a mixture of $Al_2O_3$ and $Si_3N_4$ is applied or laminated on a silicon dioxide film. The known insulating single or double film is, however, unstable during the production or operation of the semiconductor device, and does not have a dense structure. Furthermore, it is inevitable that an interface is caused between the insulating film and the silicon substrate when it is applied by the CVD process.

In the known CVD process for producing silicon oxynitride, monosilane ($SiH_4$), ammonia ($NH_3$) and oxygen ($O_2$) are brought into reaction with each other at a temperature of, for example, $700^\circ$ C. The molar ratio of ammonia with respect to oxygen may be varied or changed gradually during the CVD period. However, the silicon oxynitride produced by this CVD process possesses structural defects. The inventors of the present invention believe that the structural defects are caused by the fact that intermediate reaction products of the CVD reaction are incorporated into the insulation film.

A further disadvantage of the CVD process mentioned above is that it is difficult precisely to adjust the thickness of the silicon oxynitride film, and to form a film having a thickness of 100 angstroms or less.

It is well known in the field of semiconductor devices to use silicon dioxide ($SiO_2$) as an insulating film on a semiconductor silicon substrate. Since the semiconductor device is required to operate both reliably and stably for a long period of time, contamination of the semiconductor substrate surface, which is believed to be the major reason for deterioration in its reliability, is prevented by covering the surface of the semiconductor substrate with a silicon dioxide film. Silicon dioxide is the insulating material which is most frequently used for such covering, namely for surface passivation.

It is also known that a single film of silicon dioxide cannot effectively prevent the surface of the semiconductor substrate from being contaminated by contaminants, such as moisture or sodium ions, from outside the semiconductor device. Accordingly, an upper film of alumina ($Al_2O_3$) is sometimes applied on the film of silicon dioxide. Instead of the alumina film, a phosphorus glass layer, a boron glass layer or a lead glass layer may be formed on the silicon dioxide film. The formation of the phosphorus glass layer or phosphorus treatment can be simply carried out and effectively passivates the semiconductor surface. Although the phosphorus treatment is most frequently used in the industrial production of semiconductor devices, the surface of the passivation film, on which the phosphorus is impregnated, is hygroscopic and, hence, unstable.

It is also known that the silicon dioxide film, which can be formed by directly oxidising the silicon substrate, is superior to an insulating film directly, deposited on the silicon substrate by the CVD process. This is because the CVD process involves a contamination of the interface between the film and substrate due to vapour sources.

In the MIS (metal-insulator-semiconductor) type FETs (field effect transistors) or MISFETs, the gate insulation films conventionally used include a silicon dioxide film, a double structure film composed of a lower silicon dioxide layer and an upper silicon nitride or oxynitride layer, and a silicon oxide film, which is subjected to the phosphorus treatment mentioned above. The silicon dioxide film used for the gate insulation film of MISFETs is formed by the thermal oxidation of silicon. However, since silicon dioxide is not inherently dense, MISFETs with excellent properties and large scale integrated circuits cannot be produced from the silicon dioxide film. In the double structure film mentioned above, structural defects are liable to form at the interface of the two layers, with the result that the structural defects act as recombination centres for the change carriers. Due to the structural defects, the operation of the MISFETs having the gate insulation film of double structure becomes unstable. When a high electric field amounting to $10^6$ V/cm is applied to the gate insulation film of the MISFETs, the instability problem due to the structural defects is serious, because the threshold voltages ($V_{TH}$) of the gate are scattered and varied during the operation of the MISFETs.

When the conventional silicon dioxide film, which is subjected to the phosphorus treatment, is subjected to a high electric potential, polarisation is induced in the silicon dioxide film, with the result that the electric potential of the semiconductor substrate surface is varied. This variation of the electric potential results in instability of the MISFETs.

Diffusion of impurities into a semiconductor substrate is an indispensable step in the production of a semiconductor device. Diffusion is frequently carried out by a selective diffusion technique in which an insulating mask is used.

It is known that a thermal oxidation film of silicon dioxide (SiO2) can be used for the diffusion mask, but that such film does not form an effective mask against particular kinds of impurities, for example, gallium or boron. With regard to gallium, the gallium atoms enter the silicon dioxide film and then the underlying semiconductor substrate. The impurity boron, which is usually diffused under a hydrogen atmosphere into the semiconductor substrate, also enters the silicon dioxide film through the auxiliary action of the hydrogen. A thermal oxidation film of silicon dioxide cannot, therefore, be used as a mask in the selective diffusion of gallium and boron.

It is also known that a film of silicon nitride ($Si_3N_4$) formed by the CVD process can be used as a diffusion mask. However, a thin silicon nitride film which is formed by the CVD process on the silicon substrate lacks unifomity, whilst a thick silicon nitride film is liable to generate thermal stresses or cracks between the semiconductor substrate and the silicon nitride film.

In the production of semiconductor devices, metallic material is frequently deposited over an insulating film for the purposes of, for example, bonding metallic leads on a semiconductor substrate provided with an insulating film and for producing a multi-layer wiring structure of integrated circuits. Since silicon dioxide (SiO2) is frequently used as the insulating film, metals having superior adhering property with the silicon dioxide, such as aluminium (Al), molybdenum (Mo), polycrystalline silicon, chromium (Cr) and titanium (Ti), are used for the conductor material. The more the metals are oxidation reactive, the higher the bonding strength between the insulating film and the metal. At the interface between the highly oxidation-reactive metal film and the silicon dioxide film a transitional layer is created after the deposition of the metal film in which layer the metal is oxidised by the oxygen of the silicon dioxide. It is believed by experts in the field of semiconductor technology that the adhering property of the metals mentioned above is increased by this transitional layer. However, the insulating properties of a thin silicon dioxide film deteriorate by this reaction between the metal and silicon dioxide, namely, by the removal of oxygen from the silicon dioxide film.

A conventional capacitor used in integrated semiconductor devices has a structure in which an insulating film is deposited on a metal or semiconductor substrate and is coated by a counter electrode made of metal. Since capacitors for such semiconductor devices are required to be compact and inexpensive, and to have a large capacitance, a film made of silicon dioxide (SiO2) alumina ($Al_2)_3$) and silicon nitride ($Si_3N_4$) was conventionally used as their dielectric. This is because silicon dioxide can be produced simply by heating the semiconductor silicon substrate in an oxidising atmosphere, and the so produced silicon dioxide film is thin and free from such defects as pinholes. However, the thermally oxidised film of silicon is disadvantageous because of the facts that such film has low dielectric constant, is not highly resistant to emission of radiation and is not highly resistant to contamination from the outside of the semiconductor device.

The alumina ($Al_2O_3$) of the above mentioned film is generally formed by the CVD process or an anodic oxidation process and has a high dielectric constant. However, when the alumina film is thin, its leakage current is large and results in a current loss in the capacitor that is above an acceptable level.

The silicon nitride ($Si_3N_4$) of the above mentioned film may be formed by thermally nitridating silicon but the thickness of such a nitride film is limited, so that the maximum allowable voltage of such nitride film raises a problem.

It is also known that films of silicon mono-oxide (SiO), tantalum oxide ($Ta_2O_5$) and titanium dioxide ($TiO_2$) can be used for the capacitor. However, the qualities of the films of these oxides are poor.

US-A-3385729 discloses a process for producing an insulating layer in a semiconductor device by thermally growing a silicon dioxide film on a silicon substrate. The silicon dioxide film is treated with high purity anhydrous ammonia forming a silicon nitride layer of 50-200nm depth. Polycrystalline silicon is vapour-deposited on the silicon nitride layer.

It is, therefore, an object of the present invention to provide a process for forming a dense insulating film for semiconductor devices which does not have the disadvantages of the conventional insulating films.

According to this invention there is provided a process for forming a semiconductor device having a metal-insulator semiconductor-structure comprising a silicon semiconductor substrate, an insulating film formed on the silicon semiconductor substrate and a metal portion formed on the insulator, wherein said insulating film has a thickness of 3-18nm and comprises a thermally oxidised silicon dioxide film having a lower surface thereof above said silicon semiconductor substrate, the upper surface portion of the silicon dioxide film comprising an at least partially nitridated portion and containing a uniform and dense silicon oxynitride layer , and said silicon oxynitride layer having a distribution of nitrogen content which decreases gradually from the upper surface towards the interior of the silicon dioxide film, the process comprising forming a film of silicon nitride having a thickness of 2-10nm by thermal nitridation on the silicon semiconductor, oxidising a portion of the nitride film to form the silicon dioxide film, and heating the silicon dioxide film in a nitridating atmosphere to convert at least part of the exposed surface of the silicon dioxide film to silicon oxynitride.

The insulating film so formed according to this invention includes a silicon nitride or a so called silicon nitride and a so called silicon oxynitride, which is a silicon dioxide in which oxygen atoms are replaced, although not stoichiometrically, by nitrogen atoms. The silicon oxynitride formed by the present invention is distinguished from the known silicon oxynitride, formed by a CVD process using $NH_3$, $SiH_4$ and $O_2$ gases since an oxidation film of silicon is subjected to a nitridating step in accordance with the present invention. The silicon oxynitride film according to the present invention is also distinguished from the known, double structure film of a lower, silicon dioxide layer and an upper, silicon nitride layer, because in the known structure, the silicon nitride layer is deposited on the silicon dioxide layer whilst in the present invention the silicon dioxide layer is at least partly nitrided or impregnated with nitrogen. Accordingly, the insulating film made in accordance with the present invention does not have the disadvantages, such as the formation of structural defects therein and contamination of the interface between such a film and the semiconductor silicon substrate.

The insulating film made in accordance with the present invention includes a silicon nitride film, but it is distinguishable from a silicon nitride film formed by direct thermal nitridation of the silicon substrate. In the direct thermal nitridation of silicon, the silicon is heated to an elevated temperature in an ammonia atmosphere, and nitrogen atoms diffuse from the atmosphere into the substrate. The rate determining step in the direct thermal nitridation of silicon is, therefore, the diffusion step and, as a result, the growth rate of the nitride film reduces with the increase in thickness of the growing film, which impedes the diffusion of the nitrogen atoms. Accordingly, it is difficult to form a nitride film having a thickness of 100 angstroms or more by the direct thermal nitridation of silicon.

It is known to form a silicon dioxide film by thermal oxidation of a semiconductor silicon substrate this comprises the step of heating the substrate to an elevated temperature of from 600 to 1200°C in an oxidising atmosphere of, for example, oxygen or water. Depending on the purpose of the silicon dioxide film, the thickness of the film is selected to be in the range of from 3 to 2000nm.

The thermal oxidation of silicon is suitable for preventing the increase of electric charges on the surface of the silicon substrate to a level of more than $10^{12}$ cm$^{-2}$.

The nitridation process of the silicon dioxide film in the process according to the present invention includes a step of heating the silicon dioxide film formed above the the silicon substrate, preferably to a temperature of from 900 to 1300°C, and more preferably from 1000 to 1200°C in a nitradating atmosphere. Such atmosphere preferably comprises ammonia ($NH_3$) or hydrazine ($N_2H_4$). The nitridation atmosphere may also contain an inert gas such as argon, and residual gases such as oxygen. The flow rate of the gas should be from 100 to 50000 cc/ minute. The nitridation time should be at least 1 minute. The maximum nitridation time is dependent upon the extent of the desired nitridation. Thus, the nitridation time is increased when nitrogen is to be introduced to a large depth in the silicon dioxide film, and/or when the molar ratio of nitrogen to oxygen in the nitrided film is required to be high. The inventors believe that nitrogen atoms in the nascent state are formed from the decomposition of the ammonium or hydrazine, which atoms participate in the formation of the silicon oxynitride. Since experiments by the inventors have shown that no silicon oxynitride was formed by the heat treatment using molecular nitrogen gas, it is essential to use gaseous compounds, such as $NH_3$ and $N_2H_4$, or ionised nitrogen in the form of a plasma for the nitridation atmosphere.

The nitridation process of the silicon dioxide film according to the present invention also includes the steps of forming a film consisting essentially of a silicon nitride on a silicon substrate , by subjecting the substrate to a direct thermal nitridation, oxydising a portion of the nitride film and subsequently heating the silicon substrate in a nitriding atmosphere to convert at least a portion of the oxidised surface to a silicon nitride.

The process for forming a direct thermal nitride film of silicon preferably comprises a step of heating the silicon substrate in a nitrogen containing atmosphere to a temperature of from 900 to 1300°C , preferably from 1000 to 1200°C for a period of from 0.01 to 100 hours. The nitriding atmosphere may comprise a nitrogen compound , such as ammonia or hydrazine ($N_2H_4$). The nitrogen compound is preferably ammonia. The direct thermal nitride film of silicon preferably has thickness of from 2 to 10nm, more preferably from 3 to 5 nm. Such a nitride film can be formed by using a nitridation atmosphere in which oxidant impurities, such as oxygen, water, carbon dioxide, etc., are reduced to a level of less than 100 ppm and by adjusting the nitridation temperature to a range of from 1200 to 1300°C.

It is preferable to completely clean the silicon substrate prior to the nitridation, by degreasing the silicon substrate in an organic solvent, boiling in an acid solution, preferably sulfuric and nitric acid, and etching in hydrofluoric acid. Prior to forming the direct thermal nitride film of silicon, it is preferable to heat the silicon substrate in an inert gas atmosphere at a temperature of from 900 to 1300°C.

The oxidation step preferably comprises heating the semiconductor silicon substrate provided with the nitride film to a temperature of from 500 to 1300°C, preferably from 900 to 1200°C, in an oxidizing atmosphere of oxygen or water. The film consisting essentially of silicon nitride is gradually changed to silicon oxide by oxygen atoms, which diffuse from the surface to the interior of the film. Silicon oxide or silicon oxynitride is, therefore, formed on the oxidized surface of the film. In the oxidation step mentioned above, the thickness of the oxidized, silicon nitride film is increased because the oxide film grows to a thickness of from 3 to 19 nm, preferably from 5 to 9nm. The total thickness of the silicon nitride and the oxydized film is increased from the thickness of the nitride film directly after the thermal nitridation of silicon.

The final nitridation step of the oxidized surface of the nitride film is carried out in the manner as in the nitridation of the silicon dioxide film, explained hereinabove. The nitride film is usually formed, however, a film composed of a mixture of the oxide and nitride is formed when the nitridation time is short.

Nitrogen atoms can easily diffuse through the upper oxidized film of the silicon nitride and reach the lower nitride film of silicon, which is formed by the first step of direct thermal nitridation and which is in contact with the semiconductor silicon substrate. Since the thickness of the lower nitride film is reduced as compared with that directly after the direct thermal nitridation of silicon, the nitrogen atoms can further diffuse through the lower nitride film onto the surface of the semiconductor silicon substrate. A new silicon nitride film is, therefore, formed on the surface of the semiconductor silicon substrate. Furthermore, the oxide film formed by the direct thermal nitridation step is gradually converted to silicon nitride film during the final nitridation step. The silicon nitride film after the final nitridation step is advantageously dense and has a thickness in the range of from 3, to 18nm, preferably from 6 to 14 nm. The silicon nitride film having the thickness mentioned above is particularly suitable for the gate insulation film of MISFETs.

An advantageous nitridation process for a thermal oxidation film of silicon comprises a step of heating the semiconductor silicon substrate and the silicon dioxide film formed thereon to an elevated temperature in an atmosphere of plasma gas which contains nitrogen atoms. The plasma gas atmosphere can be generated from a nitrogen-containing gas or gases. Such gas is, preferably, ammonium, hydrazine or nitrogen. The nitrogen-containing gas can be mixed with hydrogen, hydrogen chloride or chlorine gases. The plasma gas may be generated by heating the source gas under a reduced pressure of from 0.01 to 10 (1.3 Pa to 1.3 KPa) Torr by means of an electric discharge. The electric charge is induced in a space in which the source gas is confined, by applying a high frequency current of from 50 to 1000 KHz and a voltage of from 1 KV to 100 KV. The nitridation process using the plasma gas is advantageous because various kinds of gases can be used and, further, the heating temperature is low, i.e. in the range of from 800 to 1300°C, preferably from 800 to 1100°C. The nitridation time using the plasma gas is reduced compared to that when using non plasma gases.

The insulation films comprising the silicon oxynitride or the silicon nitride produced according to the present invention are not liable to contamination by impurities, such as moisture, and sodium and potassium ions. The surface state density ($N_{ss}$) of the insulation film is decreased considerably by the nitridation of silicon dioxide to a level of approximately $5 \times 10^{11}$ to $1 \times 10^{10}/cm^2$ at a silicon surface potential of 0.3eV. It is believed by the Inventors that, because of a decrease in the drift of sodium ions due to the nitridation, the behaviour of the capacitance change depending upon the voltage applied to the insulation film is decisively influenced by injection of carriers into a trap level, which is present in the proximity of the interface between the silicon substrate and the insulation film comprising the silicon dioxide.

In the nitridation by the non plasma gas, it is preferable to select the heating time in the range of from 1 to 5 hours and the heating temperature in the range of from 1000 to 1200°C, so as to provide the insulation film with a low $N_{ss}$. In the nitridation by the plasma gas, it is preferable to select the heating time in the range of from 1 to 5 hours and the heating temperature in the range of from 1000 to 1200°C, so as to provide the insulation film with a low $N_{ss}$.

Under a high electric potential, the insulation films produced according to the present invention do not exhibit such disadvantageous behaviors as the movement of ions and the capturing phenomena of carriers in the film.

The insulation film comprising the silicon oxynitride and the silicon nitride produced according to the present invention, have a high relative dielectric constant ranging from 4 to 5.3. Furthermore, the insulation films made according to the present invention have a high breakdown voltage in the range of from 11 to 12 MV/cm. The breakdown voltage is increased as the nitridation time increases.

The silicon oxynitride film is highly resistant against etching solutions used in the production of semiconductor devices, such as hydrofluoric acid, ammonium floric acid and their mixed solution. The resistance against etching solution is increased with an increase in the nitridation time.

The insulative film, which is formed by successive direct thermal nitridation, oxidation and nitridation steps, is dense and includes no structural defects.

The molar ratio of nitrogen to oxygen in the silicon oxynitride generally ranges from 1:10 to 10:1.

The insulative films are formed according to the present invention by the nitridation of at least a portion of the thermal oxidation film of silicon nitride film. These films present no such inconveniences as: contamination of the interface between the semiconductor substrate and the film due to the formation of the film, and; polarization of carriers in the films caused by the electric field. Property variation of the insulative films due to movable ions is favourably suppressed by the nitridation of the silicon dioxide.

Because of the facts mentioned above, the insulative films produced according to the present invention are suitable for use as a passivation film of a semiconductor device and a gate insulation film of an MISFET.

To produce a dense passivation film in the range of from approximately 3 to 18 nm, the direct thermal nitridation, thermal oxidation and nitridation of the silicon substrate are performed successively. The direct thermal nitridation should be performed in such a manner that the nitride film grows to a thickness of from approximately 2 to 10 nm, preferably from 3 to 7 nm. The thermal oxidation time should be from approximately 0.01 to 100 hours, preferably from 0.1 to 10 hours. The nitridation after the thermal oxidation step should be carried out from approximately 0.01 to 100 hours, preferably from 0.1 to 10 hours.

Since an electrode or wiring etc., are usually formed on the top surface of the semiconductor devices, not the thermal oxidation film of the silicon substrate but a silicon dioxide film, which is deposited on such top surface by a CVD, sputtering or vacuum evaporation process, may be subjected to the nitridation, and is used for the passivation film. The passivation films produced according to the present invention are highly resistant to contamination from the exterior of the semiconductor device, and enable long and stable operation of the semicondutor devices, with constant performance, even at high temperature.

The insulative films produced according to the present invention are also suitable for use as a gate insulation film of an MISFET.

The nitridation time of the silicon dioxide film should be from approximately 0.01 to 100 hours in a plasma and non plasma atmosphere.

To produce a dense gate insulation film in the range of from approximately 3 to 19 nm, the direct thermal nitridation, thermal oxidation and nitridation of the silicon substrate are performed successively. The direct thermal nitridation should be performed in such a manner that the nitride film grows to a thickness of from approximately 2 to 10 nm, preferably from 3 to 7 nm. The thermal oxidation time should be from approximately 0.01 to 100 hours, preferably from 0.1 to 10 hours. The nitridation after the thermal oxidation step should be carried out from approximately 0.01 to 100 hours, preferably from 0.1 to 10 hours.

The gate insulation film produced according to the present invention is highly resistant to contamination from the exterior of the semiconductor device. At least one MISFET of a semiconductor device has the insulative films, which are formed by the nitridation of a direct oxidation film of a semiconductor silicon substrate and operates stably over a long period of time because of the excellent properties of the insulative films. In addition, the variation of the threshold voltage of the MISFETs is considerably lower during the operation thereof than that of the MISFETs having a conventional gate insulation film. Furthermore, no problems of a decrease in mutual conductance (gm) and an increase in the surface state density ($N_{ss}$) are presented during the operation of the MISFETs. The MISFETs according to the present invention are especially suitable for the elements of large scale integrated circuits.

When MISFETs are provided with the field insulation film made of the insulative films produced according to the present invention, the MISFETs are particularly advantageous in view of their stable operation. In order to produce such MISFETs, it is preferable to simultaneously subject the field and gate insulation films of silicon dioxide to nitridation. The nitride surface of the field insulation film is not removed when selectively removing the gate insulation film, so as to form windows for the source and drain of an MISFET. It is, however, possible to entirely remove the nitride surface of the field insulation film, and subsequently, to subject the field insulation film to nitridation.

In MISFETs a metal selected from the group consisting of aluminium, molybdenum, polycrystalline silicon, chromium and titanium, or especially the oxidation reactive metals, i.e., aluminium and molybdenum, can be advantageously used in combination with the insulative films produced according to the present invention for the gate insulation film. This is because these insulative films can effectively prevent the formation of a transitional layer. A transitional layer is formed by the reaction between the oxide film and the film of the metals mentioned above, while almost no such layer is formed by the reaction between the insulative films formed by the nitridation of the silicon oxide and the metals mentioned above. Since the surface of these insulative films is composed of silicon oxynitride, and thus contains oxides, a small amount of the transitional layer can be present due to the reaction between the oxides and the metals. However, the exsistence of oxides contribute to the enhancement of bonding strength of the metals with the insulative film. On the other hand, the existence of nitride in the insulative films prevents the unlimited increase of the transional layer.

In semiconductor devices, such metals as gold, aluminium and molybdenum, are used for wiring conductors and are deposited on an insulative material such as silicon dioxide. When the conductor and the silicon dioxide are heated to an elevated temperature, a reaction between the conductor and the silicon dioxide occurs. When such reaction causes an increase in the resistance and a property deterioration of the conductor, such reaction is undesirable and should be prevented. In the insulative films, produced according to the present invention, the disadvantages mentioned above can be eliminated when heating the conductor and insulative material at a temperature ranging from 100 to 1200°C.

To produce a dense insulative films in the range of from approximately 3 to 18 nm, the direct thermal nitridation, thermal oxidation and nitridation of the silicon substrate are performed successively. The direct thermal nitridation should be performed in such a manner that the nitride film grows to a thickness of from approximately 2 to 10 nm, preferably from 3 to 7 nm. The thermal oxidation time should be from approximately 0.01 to 100 hours, preferably from 0.1 to 10 hours. The nitridation after the thermal oxidation step should be carried out from approximately 0.01 to 100 hours, preferably from 0.1 to 10 hours.

When polycrystalline silicon is used for the gate electrode of the MISFETs, the MISFETs are advantageously produced by the process which comprises a step of simultaneous oxidation of: the surface of the polycrystalline silicon film having a pattern of the gate electrode, and; the surface of an insulative film, which is formed on the active region of the MISFETs and which is partly masked by the gate electrode pattern. At least a portion of the silicon dioxide of the insulative film is converted to a silicon nitride at least at a surface portion of the silicon dioxide film. In the simultaneous oxidation step, the oxidation is carried out in such a manner that the silicon oxynitride of the insulative film mentioned above is converted essentially to silicon dioxide. Since the oxidation rate of the polycrystalline silicon is considerably higher, i.e., approximately 8-100 times, than that of the silicon oxynitride, the thickness of the oxidation film on the polycrystalline film is from 500 to 2000nm and thus considerably greater than the thickness of the silicon oxynitride layer, which is oxidized by the simultaneous oxidation. This fact enables the selective removal of the oxidation film on the silicon substrate and thus, exposure of the substrate. The source and drain regions of MISFETs can be formed on the exposed portions of the substrate. Instead of conventional insulative masks as a PSG film for covering the gate electrode, the silicon dioxide film which is produced by the oxidation of the insulative film mentioned above is used for the gate electrode itself. In order to expose the source and drain regions, it was conventionally necessary to use the pattern of these regions and, then, to selectively remove the PSG film for the purpose of only forming windows through such PSG film. On the other hand, by means of the simultaneous oxidation step mentioned above, the windows for the source and drain regions can be simply formed by means of a selfalignment technique with the insulative film covering the gate electrode. In addition, because of the non employment of the PSG film, the width of each of the source and drain regions can be reduced to from 1 to 4 microns, for example 2 microns. The conventional sized, source and drain regions had width of 6 microns. In order to form the source and drain regions, impurity ions may be ion implanted through the oxynitride layer and oxide layer or diffused after removal of these layers. It is possible to dope the impurity ions into the polycrystalline silicon film at the same time as the implantation of ions into the source and drain regions.

The simultaneous oxidation method as explained above can be utilized for the production of RAMs (random access memories) which comprise a capacitor element for storing electric charges or carriers and a gate element of an MOSFET element. In an advantageous process for producing the RAMs, an insulative film, the surface of which is subjected to a nitridation, is formed on a semiconductor silicon substrate to a thickness of from approximately 3 to 500nm. A polycrystalline silicon film having an electrode pattern of the capacitor element is deposited on the insulative film, and subsequently, both the polycrystalline silicon film and the insulative film are simultaneously oxidized in the manner explained previously. As a result of this oxidation, a silicon dioxide film having a thickness in the range of from approximately 50 to 2000 nm is formed on the polycrystalline silicon film for the electrode of the capacitor element. The thickness of the insulative film mentioned above is not increased an appreciable amount by the simultaneous oxidation. After the simultaneous oxidation, a conductive material film, such as a film of aluminum or polycrystalline silicon, is deposited both on the silicon dioxide film and the insulative film which is oxidized due to the simultaneous oxidation. The conductive material film is then selectively removed to form an electrode pattern of the transistor gate. Accordingly, the transistor gate electrode and the memory cell electrode are completely isolated by a thick silicon dioxide film which is formed on the latter electrode.

In the process for producing the RAMs explained hereinabove, it is important that the film of silicon dioxide film between the electrodes of transistor gate and memory cell be considerably thicker than the insulative film of transistor gate. If the thickness of the silicon dioxide film is as thin as that of the gate insulative film, short circuits between the electrodes of the transistor gate and the memory cell are liable to occur.

Instead of the polycrystalline silicon, a polycrystalline metal silicide, such as platinum silicide or molybdenum silicide, can be used.

Insulative films are also suitable for use as a mask against selective diffusion of impurities into a semiconductor silicon substrate. One of the insulative masks, i.e. the nitridation film of a silicon dioxide film, which is dioxide film formed by a thermal oxidation of silicon, is stable at an elevated temperature of even $1200°C$ and has an excellent adhering property with the substrate, because the silicon dioxide is formed by a thermal oxidation of the silicon substrate. Since the surface of such silicon dioxide film is replaced in the diffusion mask by the silicon nitride, having a dense structure, the impurity diffusion through the mask is prevented with a certainty and hence selective diffusion is performed in a desirable manner.

When a direct thermal nitridation, thermal oxidation and nitridation of the silicon substrate are performed successively the direct thermal nitridation should be performed in such a manner that the nitride film grows to a thickness of from approximately 2 to 10 nm, preferably from 3 to 7 nm. The thermal oxidation time should be approximately from 0.1 to 100 hours, preferably from 0.1 to 10 hours. The nitridation after the thermal oxidation step should be carried out from approximately 0.1 to 100 hours, preferably from 0.1 to 10 hours.

By means of the diffusion mask produced by the process of the present invention, the selective diffusion can be carried out by using a very thin mask, with the result that the mask does not cause any thermal stress on the silicon substrate during the diffusion step. Side diffusion does not occur due to the excellent adherence between the thermal oxidation $SiO_2$ layer of the diffusion mask and the silicon substrate. Accordingly, it is possible to produce fine diffused as on the silicon substrate. Furthermore, although the conventional, silicon dioxide mask cannot mask the silicon substrate against the impurity boron under a hydrogen atmosphere, no such problem as the boron diffusion through the mask occurs during the diffusion and heat treatment steps when using the diffusion mask of the present invention. A property deterioration of the $SiO_2$ layer and a property deterioration of an interface between the $SiO_2$ layer and the silicon substrate are advantageously prevented by the diffusion mask of the present invention.

The insulative films are furthermore suitable for use as the dielectric material of a capacitor of the semiconductor devices. An electrode is deposited on each of these insulative films.

To produce a dense, insulative material film in the range of from approximately 3 to 18nm, the direct thermal nitridation, thermal oxidation and nitridation of the silicon substrate are performed successively. The direct thermal nitridation should be formed in such a manner that the nitride film grows to a thickness of from approximately 2 to 10 nm, preferably from 3 to 7 nm. The thermal oxidation time should be approximately from 0.1 to 100 hours, preferably from 0.1 to 10 hours. The nitridation after the thermal oxidation step should be carried out from approximately 0.1 to 100 hours, preferably from 0.1 to 10 hours.

The insulative material of the capacitor produced by the process of the present invention exhibits higher dielectric constant than the dielectric constant of silicon dioxide. The relative dielectric constant of the insulative material according to the present invention is generally from 4 to 6. Since the insulative material can be made thin, it is possible to manufacture a capacitor having a high capacitance value from such insulative material. This capacitance value is approximately 30% higher than that of the conventional capacitor using a silicon dioxide as the dielectric material.

A semiconductor memory cell produced by a process according to the present invention is characterized by including the excellent capacitor element mentioned above on the semiconductor silicon substrate. Consequently, the amount of electric charges stored in a memory cell of the semiconductor device of the present invention is 30% higher than that in the case of using the conventional capacitor mentioned above. Accordingly, it is possible to read out the memory cell with a very low error rate.

It is possible to reduce the thickness of the insulating material in a capacitor to between 3 to 10nm. Since a large electric charge can be stored in a memory cell using a thin insulating film for a capacitor element of the memory cell, the area of the memory cell can be reduced to less than that used previously.

The process for producing a capacitor in accordance with the present invention is essentially the same as that for the MIS structure. However, a metal film deposited on the insulating material should be shaped to an effective electrode pattern of a small area ranging from 100mm$^2$ to $1 \times 10^{-6}$mm$^2$,so that a compact capacitor can be produced.

When, instead of manufacturing the capacitor element as an integral portion of the silicon substrate the capacitor element is to be formed as a separate element, the silicon substrate is cut around the metal electrode.

Various examples of methods in accordance with this invention will now be described and contrasted with earlier, control examples, with reference to the accompanying drawings; in which:-

Figures 1 to 6 are cross sections through a semiconductor device at various stages during the formation of an MISFET element by a process outside the scope of the present invention;

Figures 7 to 10 are cross sections through a semiconductor device at various stages during the formation of an insulating layer; and

Figures 11 to 13 are cross sections through a semiconductor device at successive stages showing the formation of a RAM element by a process outside the scope of the present invention

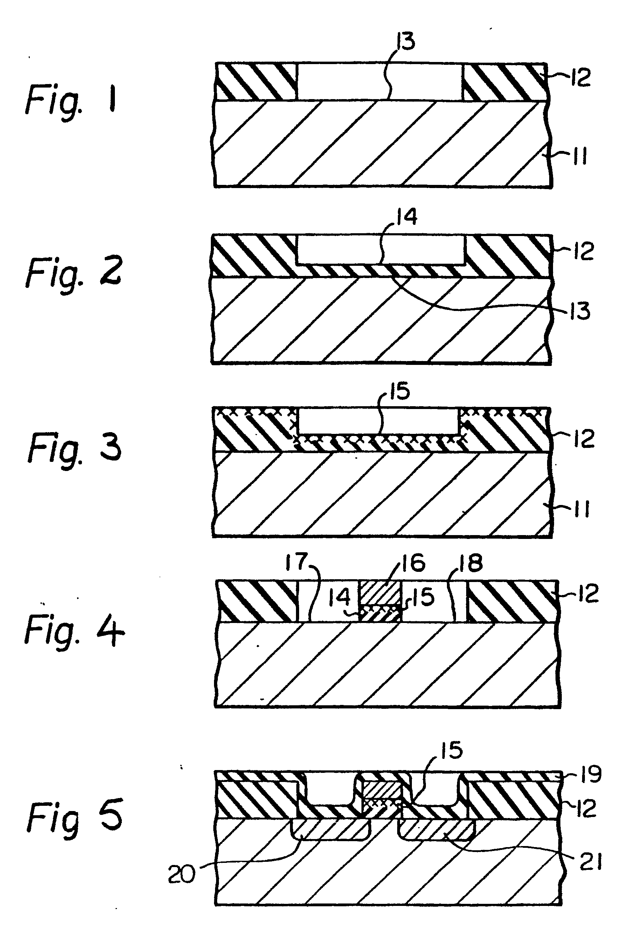

An MISFET was produced by a process outside the scope of the present invention as explained with reference to Figs.1 through 6 .

Referring to Fig.1 , silicon dioxide film 12 was formed by thermal oxidation of a P-type silicon substrate 11, having a resistivity of 1 Ω•cm and including a boron dopant. A window was formed through the silicon dioxide film 12, so as to leave this film as a field insulation film. The window exposed an active region 13 of the substrate 11.

Referring to Fig. 2, the active region 13 of silicon substrate exposed through the window was subjected to a thermal oxidation similar to that explained in Example 1, and a silicon dioxide film 14, for the gate insulation film, having a thickness of 50 nm was formed. Nitridation of the silicon oxide films 12 and 14 was performed under the conditions of heating the substrate 11, under an NH$_3$ atmosphere, at 1100°C for 30 minutes. The surface of the oxide films 12 and 14, for the field and gate insulations, respectively, which was converted to silicon oxynitride, is schematically shown in Fig. 3 by number 15 and "X" marks.

Referring to Fig. 4 , a polycrystalline silicon film 16 was deposited by a CVD process on the silicon oxynitride 15 to a thickness of 300 nm and then, selectively removed to produce an electrode pattern of a gate of the MISFET. The insulative film (the original oxide film 14 and the silicon oxynitride film 15) was, therefore, partly exposed, and then, the exposed insulative film was removed by an etching solution of a buffered hydrofluoric acid. During the etching, the polycrystalline silicon film 16 masked the underlying insulative film. The etching was terminated when the silicon substrate 11 was exposed. Windows 17 and 18 for the diffusion of the source and drain of the MISFET were formed by the etching.

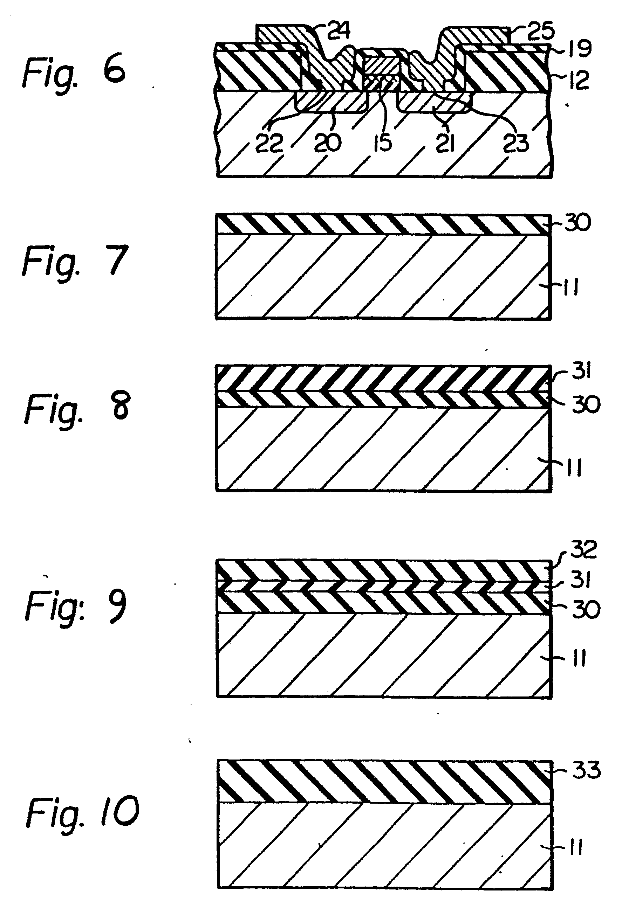

Referring to Fig. 5 , a phospho-silicate glass (PSG) film 19, containing 5% of phosphorus, was deposited by a CVD process to a thickness of approximately 300 nm.

Subsequently, the PSG film 19 was heated to 1000°C, for 30 minutes, in a nitrogen atmosphere, thereby diffusing the phosphorus from the PSG film 19 into the substrate 11. An n$^+$ type, source region 20 and drain region 21 were, therefore, formed on the diffused surface of the substrate 11.

Referring to Fig. 6, the PSG film 19 was selectively removed to expose the source and drain regions 20 and 21, respectively, so that contact windows 22 and 23 of the electrodes were formed. Aluminum was deposited on the substrate and selectively removed to form the pattern of a source electrode 24 and a pattern of the drain electrode 25.

Example 1

The present Example describes a method for forming a gate insulation film of an MISFET. Referring to Fig. 7, a thin layer 30 of silicon nitride was formed on a P-type semiconductor silicon substrate 11 having a resistivity of 10 Ω•cm, by heating the substrate 11 at 1100°C, for 30 minutes, in an NH$_3$ atmosphere. The thin layer 30 had a thickness of approximately 4 nm and was essentially composed of the silicon nitride.

Referring to Fig. 8, the thin nitride layer 30 was partly converted to an oxidized layer 31 by heating the thin nitride layer 30 to 1100°C, for 30 minutes, in an oxygen atmosphere, the oxygen of which was bubbled through water at 80°C. Due to the heating in the oxygen atmosphere, the surface of the thin nitride layer 30 was oxidized to the layer 31, with the result that the thickness of the nitride layer 30 was reduced to 1 nm. Since the thickness of the oxidized layer 31 was 6 nm, the total thickness of the insulative layers 30 and 31 was 7 nm.

Referring to Fig. 9 , the oxidized layer 31 was partly converted to a nitrogen-diffused layer 32 by again heating the substrate 11 to 1100°C, for a period of 1 hour, in an NH$_3$ atmosphere. Since nitrogen atoms were diffused from the atmosphere into the substrate 11 through the oxidized layer 31, the nitrogen content in the substrate 11 and the oxidized layer was gradually increased. The thickness of the layer 30 was, therefore, increased.

Example 2

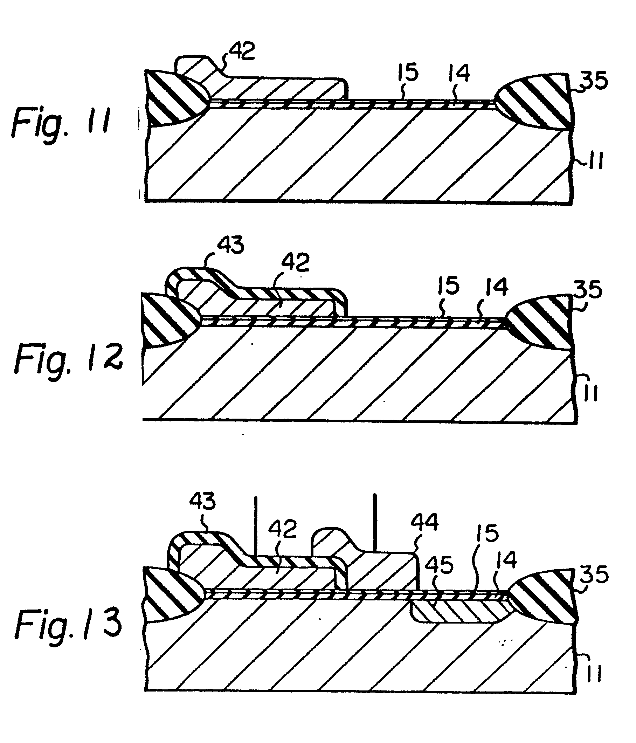

The process of Example 1 was further continued, so that the nitridation time related to Fig. 9 amounted to 5 hours. As seen in Figs. 9 and 10, the layers 30, 31 and 32 on the substrate 11 were completely subjected to the nitridation, and a nitrided film 33 having a thickness of 7 nm as formed.

Figures 11-13 show a further process outside the scope of the present invention. A doped, polycrystalline silicon film 42 was deposited on the insulative films 14 and 15 and, then, selectively removed.

Referring to Fig. 12, a silicon dioxide film 43 having a thickness of approximately 200 nm was formed on the polycrystalline silicon film 42 by heating the elements illustrated in Fig.11 at 1150°C, for 60 minutes, in a dry oxygen. The exposed silicon oxynitride layer 15 was not completely oxidized by the heat treatment, and a part of the silicon oxynitride remained on the surface of the silicon substrate 11. The elements 42, 43, and the portion of the insulative films 14, 15 and the silicon substrate 11 under these elements 42, 43 constitute a carrier storing element of a RAM (random access memory).

Referring to Fig. 13, a polycrystalline silicon film 44 for the gate electrode of a transistor was deposited on the silicon dioxide film 43 and the silicon oxynitride layer 15. The silicon oxynitride layer 15 was oxidized by the oxidation explained in connection with Fig. 24 but still contained silicon nitride. The polycrystalline silicon film 44 was shaped into a pattern of a gate electrode. Subsequently, arsenic ions (As$^+$) were ion implated at an energy of 150 keV and a dosing amount of $2 \times 10^{15}/cm^2$, so as to dope impurities into the polycrystalline silicon film 44 and the input-output region 45 of the transistor mentioned above. After the ion implantation, heat treatment was performed at 900°C for 30 minutes, so as to activate ion implanted impurites.

**Claims**

1. A process for forming a semiconductor device having a metal-insulator semiconductor-structure comprising a silicon semiconductor substrate, an insulating film formed on the silicon semiconductor substrate and a metal portion formed on the insulator, wherein said insulating film has a thickness of 3-18nm and comprises a thermally oxidised silicon dioxide film having a lower surface thereof above said silicon semiconductor substrate, the upper surface portion of the silicon dioxide film comprising an at least partially nitridated portion and containing a uniform and dense silicon oxynitride layer, and said silicon oxynitride layer having a distribution of nitrogen content which decreases gradually from the upper surface towards the interior of the silicon dioxide film, the process comprising forming a film of silicon nitride having a thickness of 2-10nm by thermal nitridation on the silicon semiconductor, oxidising a portion of the nitride film to form the silicon dioxide film, and heating the silicon dioxide film in a nitridating atmosphere to convert at least part of the exposed surface of the silicon dioxide film to silicon oxynitride.

2. A process according to claim 1 in which the thermal nitridation is conducted at a temperature in the range 900 to 1300°C in a nitrogen-containing atmosphere with an oxidant impurity in an amount of less than 100ppm, and wherein the oxidation of this film is conducted by heating in an oxidising atmosphere at a temperature within the range 500 to 1300°C.

3. A process according to claim 1 in which said device includes at least one MISFET element having a gate insulating film made of said insulating film.

4. A process according to claim 3 in which each MISFET element is covered by a further insulating film comprising a nitridated surface portion of a silicon dioxide film selectively formed on each MISFET element.

5. A process according to claim 1 in which the device includes at least one capacitor element having a dielectric material layer formed by the insulating film.

6. A process according to claim 1 in which the insulating film has a surface state density of 5 x 10$^{11}$ to 1 x 10$^{11}$ at a silicon surface potential of 0.3 eV.

## Revendications

1. Procédé pour la fabrication d'un dispositif semi-conducteur présentant une structure de semi-conducteur métal-isolant comprenant un substrat semi-conducteur en silicium, une couche isolante formée sur le substrat semi-conducteur en silicium et une partie métallique formée sur l'isolant, où ladite couche isolante présente une épaiseur de 3-18nm et comporte un film de dioxyde de silicium thermiquement oxydée présentant une surface inférieure placée au-dessus dudit substrat semi-conducteur en silicium, la surface supérieure du film de dioxyde de silicium comportant une partie au moins partiellement nitrurée et contenant une couche uniforme et dense d'oxyazoture de silicium, ladite couche d'oxyazoture de silicium présentant une répartition de teneur d'azote diminuant progressivement depuis la surface supérieure vers l'intérieur du film de dioxyde de silicium, le procédé englobant la fabrication d'un film d'azoture de silicium présentant une épaisseur de 2-10 nm par nitruration thermique sur le semi-conducteur de silicium, l'oxydation d'une partie du film nitruré pour former le film de dioxyde de silicium, et l'échauffement du film de dioxyde de silicium en une atmosphère de nitruration pour convertir au moins une partie de la surface exposée du film de dioxyde de silicium en oxyazoture de silicium.

2. Procédé selon la revendication 1, où la nitruration thermique s'effectue à une température située dans la plage de 900 à 1300° C en une atmosphère contenant de l'azote et présentant une teneur en impuretés oxydantes d'une valeur inférieure à 100ppm, et où l'oxydation du film s'effectue par chauffage dans une atmosphère oxydante à une température située dans la plage de 500 à 1300° C.

3. Procédé selon la revendication 1, où ledit dispositif comporte au moins un élément MISFET présentant un film isolant de porte fabriqué dans ledit film isolant.

4. Procédé selon la revendication 3, où chaque élément MISFET est recouvert d'un film isolant supplémentaire comportant une partie à surface nitrurée d'un film de dioxyde de silicium formé de façon sélective sur chaque élément MISFET.

5. Procédé selon la revendication 1, où le dispositif comporte tout au moins un élément condensateur comportant une couche en matériau diélectrique formée par le film isolant.

6. Procédé selon la revendication 1, où le film isolant présente une densité de surface de 5 x 10(à la puissance 11) à 1 x 10 (à la puissance 10) pour un potentiel superficiel de silicium de 0,3 eV.

## Ansprüche

1. Verfahren zur Bildung einer Halbleitervorrichtung mit einer Metall-Isolator-Halbleiterstruktur, mit einem Siliciumhalbleitersubstrat, einem isolierenden Film, der auf dem Siliciumhalbleitersubstrat gebildet ist, und einem Metallabschnitt, der auf dem Isolator gebildet ist, bei welchem der genannte isolierende Film eine Dicke von 3-18nm hat und einen thermisch oxidierten Siliciumdioxidfilm umfaßt, der eine untere Oberfläche oberhalb des genannten Siliciumhalbleitersubstrates hat, wobei der obere Oberflächenabschnitt des Siliciumdioxidfilms einen wenigstens teilweise nitrierten Abschnitt hat und eine gleichförmige und dichte Siliciumoxinitridschicht enthält, und die genannte Siliciumoxinitridschicht eine Verteilung des Stickstoffgehaltes hat, welche von der oberen Oberfläche zu dem Inneren des Siliciumoxinitridfilms graduierlich abnimmt, welches Verfahren die Bildung eines Films aus Siliciumnitrid umfaßt, der eine Dicke von 2-10nm hat, durch thermisches Nitrieren des Siliciumhalbleiters, Oxidieren eines Abschnitts des Nitridfilms, um den Siliciumdioxidfilm zu bilden, und Erhitzen des Siliciumdioxidfilms in einer nitrierenden Atmosphäre, um wenigstens einen Teil der dem Siliciumoxinitrid ausgesetzten Oberfläche des Siliciumdioxidfilms umzuwandeln.

2. Verfahren nach Anspruch 1, bei dem das thermische Nitrieren bei einer Temperatur im Bereich von 900 bis 1300° C in einer stickstoffhaltigen Atmosphäre durchgeführt wird, mit einer oxidierenden Verunreinigung in einer Menge von weniger als 100ppm, und bei dem das Oxidieren dieses Films durchgeführt wird durch Erhitzen in einer oxidierenden Atmosphäre bei einer Temperatur innerhalb des Bereiches von 500 bis 1300° C.

3. Verfahren nach Anspruch 1, bei dem die genannte Vorrichtung wenigstens ein MISFET-Element umfaßt, das einen Gateisolierungsfilm hat, der aus dem genannten isolierenden Film hergestellt ist.

4. Verfahren nach Anspruch 3, bei dem jedes MISFET-Element durch einen weiteren isolierenden Film bedeckt ist, der einen nitrierten

Oberflächenabschnitt aus einem Siliciumdioxidfilm umfaßt, der selektiv auf jedem MISFET-Element geformt ist.

5. Verfahren nach Anspruch 1, bei dem die Vorrichtung wenigstens ein Kondensatorelement enthält, das eine dielektrische Materialschicht hat, die durch den isolierenden Film geformt ist.

6. Verfahren nach Anspruch 1, bei dem der isolierende Film eine Oberflächenzustandsdichte von $5 \times 10^{11}$ bis $1 \times 10^{10}$ bei einem Silicium-oberflächenpotential von 0,3 eV hat.

Fig. 1

13

12

11

Fig. 2

14

12

13

Fig. 3

15

12

11

Fig. 4

17    16    18

14    15

12

Fig 5

15

19

12

20    21

Fig. 6

Fig. 7

Fig. 8

Fig. 9

Fig. 10

*Fig. 11*

42
15   14   35
11

*Fig. 12*

43   42
15   14   35
11

*Fig. 13*

43   42   44
45   15   14   35
11